# EUROPEAN PATENT APPLICATION

(11) **EP 3 916 501 A1**
(43) Date of publication of application: **01.12.2021**
(21) Application number: 19916710.7
(22) Date of filing: 28.02.2019
(51) Int. Cl.: G05B 19/418

(54) **DIGITAL TWIN MODELING AND SIMULATION METHOD, DEVICE, AND SYSTEM**

(71) Applicant: Siemens Ltd., China, Chaoyang District Beijing 100102 (CN)
(72) Inventor: LI, Chao Chun, Shanghai 201299 (CN); YU, Yan Bin, Shanghai 200270 (CN); WANG, Dong, Beijing 100102 (CN); LI, Ming, Shanghai 201204 (CN)
(74) Representative: Isarpatent
(86) International application number: PCT/CN2019/076549
(87) International publication number: WO 2020/172865

(57) **Abstract**

The present invention provides a digital twin modeling and simulation method, comprising the following steps: generating a manufacturing model ontology, acquiring field data, and generating a semantic model instance on the basis of the manufacturing model ontology and the field data; and searching for the attribute of the field data according to the type of the field data, extracting data from the semantic model instance according to the search result, and simulating the semantic model instance on a simulation platform. The digital twin modeling and simulation mechanism provided by the present invention has the flexibility of wide application and reduces the dependence on experts in this field.

## Description

### Technical Field

The present invention relates to industrial digitization, and in particular to a digital twin modeling and simulation method, device, and system.

### Background Art

With the advent of the Industry 4.0 era, we are seeing the dawn of a technological revolution that can fundamentally change the way of manufacturing. The core technology of Industry 4.0 is the digital twin. Manufacturing digitization helps enterprises shorten the production design cycle, reduce production costs, and provide digital services. On the basis of different applications, digital twins may be conceptually divided into three categories: product digital twin in the entire manufacturing process, production digital twin, and equipment digital twin.

Now, as production digital twin is closely related to performance evaluation and operation improvement in production, production digital twin is playing an increasingly important role in manufacturing digitalization. On the basis of production digital twin, production activities in a site may be fully simulated, the actual production capacity may be evaluated, and a dynamic bottleneck in the production process may also be determined. At the same time, in the production process, production digital twin may be given global optimizations, including scheduling and operation time adjustment. However, when a manufacturer attempts to produce digital twins, a developer needs to repeatedly and manually acquire data from different levels of the site, and also needs to manually plan digital twins on the basis of acquired data in commercial production modeling and software environment simulation. This is extremely time-consuming, wasting manpower, increasing the cost of data twin development, and unfavorable for the development and application of data twin technology.

In the prior art, no solution is available for the automatic generation of digital twins. Only some commercial software developers or integrators attempt to establish the backbone of the data flow through the entire production cycle, wherein the production cycle comprises: product design, process design, and production simulation. A data flow may be imported and exported from one platform to another. For example, data in the process design stage may be exported to a production simulation software program to automatically generate a model, for example, layout information. However, the above-described solution has several disadvantages, one of which is the cost problem. The above-described solution requires the purchase of commercial software for the entire industrial process, and some small manufacturers cannot afford the software purchase cost. Another disadvantage is that after some outdated production lines have gone through several rounds of upgrades, the initial process design data are no longer suitable for production digitization. Therefore, in the prior art, no digital twin modeling and simulation mechanism has been established without relying on senior professionals and experts in the field.

### Summary of the Invention

A first aspect of the present invention provides a digital twin modeling and simulation method, which comprises the following steps: S1, generating a manufacturing model ontology, acquiring field data, and generating a semantic model instance on the basis of the manufacturing model ontology and the field data; and S2, searching for the attribute of the field data according to the class of the field data, extracting data from the semantic model instance according to the search result, and simulating the semantic model instance on a simulation platform.

Further, the simulation platform comprises: a semantic search module; a device generation module; a material preparation module; an order management module; a process management module; a logic management module; a key performance index module.

Further, a resource library of the simulation platform comprises a device library, a transfer library, and a material space.

Further, the step S2 further comprises the following steps: the simulation platform, after receiving a request for generation and simulation of a production digital twin model, completes the initialization trigger, and specifies the semantic search module to perform a semantic search and obtain a search result; a routing of the semantic search module is acquired from the process management module, the device is set from a preset device library in a simulation template, the material preparation module is instructed to prepare the material with a copy of the original material entity in the material space and provide the raw material to the simulation template, and the order management module downloads orders in a predefined order sequence and provides them to the simulation template; simulation is triggered, and the process management module specifies a device and automatically selects process time before placing the product on the device in the simulation. The logic management module detects a manufacturing state in each device and, when a device has completed an operation on the basis of a part, the logic management module specifies the production part to be transported to the downstream workstation on the basis of the routing of the product; when the simulation trigger is completed, the simulation template reports the simulation state to the key performance index module and sends the key performance output needed by a customer.

Further, the manufacturing model ontology comprises individuals, class, object property, and data property.

Further, the manufacturing model ontology is divided, according to classification and attributes of site field data, into purchase order, resources, job, equipment, material, part, operation, work unit, raw material, product, routing, area, sales order, order, enterprise, and site.

A second aspect of the present invention provides a digital twin modeling and simulation system, which comprises: a processor; and a memory coupled to the processor, the memory storing an instruction that, when executed by a processor, causes the electronic device to perform actions, the actions comprising: S1, generating a manufacturing model ontology, acquiring field data, and generating a semantic model instance on the basis of the manufacturing model ontology and the field data; and S2, searching for the attribute of the field data according to the type of the field data, extracting data from the semantic model instance according to the search result, and simulating the semantic model instance on a simulation platform.

Further, the simulation platform comprises: a semantic search module; a device generation module; a material preparation module; an order management module; a process management module; a logic management module; a key performance index module.

Further, a resource library of the simulation platform comprises a device library, a transfer library, and a material space.

Further, the step S2 further comprises the following steps: the simulation platform, after receiving a request for generation and simulation of a production digital twin model, completes the initialization trigger, and specifies the semantic search module to perform a semantic search and obtain a search result; a routing of the semantic search module is acquired from the process management module, the device is set from a preset device library in a simulation template, the material preparation module is instructed to prepare the material with a copy of the original material entity in the material space and provide the raw material to the simulation template, and the order management module downloads orders in a predefined order sequence and provides them to the simulation template; simulation is triggered, and the process management module specifies a device and automatically selects process time before placing the product on the device in the simulation. The logic management module detects a manufacturing state in each device and, when a device has completed an operation on the basis of a part, the logic management module specifies the production part to be transported to the downstream workstation on the basis of the routing of the product; When the simulation trigger is completed, the simulation template reports the simulation state to the key performance index module and sends the key performance output needed by a customer.

Further, the manufacturing model ontology comprises individuals, class, object property, and data property.

Further, the manufacturing model ontology is divided, according to classification and attributes of site field data, into purchase order, resources, job, equipment, material, part, operation, work unit, raw material, product, routing, area, sales order, order, enterprise, and site.

A third aspect of the present invention provides a digital twin modeling and simulation device, which comprises:
a modeling device for generating a manufacturing model ontology, acquiring field data, and generating a semantic model instance on the basis of the manufacturing model ontology and
the field data; a simulation device for searching for the attribute of the field data according to the type of the field data, extracting data from the semantic model instance according to the search result, and simulating the semantic model instance on a simulation platform.

A fourth aspect of the present invention provides a computer program product that is tangibly stored on a computer-readable medium and comprises a computer-executable instruction, and the computer-executable instruction, when executed, causes at least one processor to perform the method according to the first aspect of the present invention.

A fifth aspect of the present invention provides a computer-readable medium storing a computer-executable instruction, and when executed, the computer-executable instruction causes at least one processor to perform the method according to the first aspect of the present invention.

A digital twin modeling and simulation mechanism provided by the present invention is capable of being applied to all types of manufacturing, and it is a manufacturing ontology based on a unified standard, which fully demonstrates the flexibility of the present invention. The present invention allows a reduction of the dependence on experts in this field for production modeling work, and a decrease in the manpower input in complex production digital twins.

### Brief Description of the Drawings

Fig. 1 is a schematic diagram of a manufacturing model ontology of a digital twin modeling mechanism according to a specific embodiment of the present invention;
Fig. 2 is a schematic diagram of a semantic model instance of a digital twin modeling mechanism according to a specific embodiment of the present invention;
Fig. 3 is a schematic diagram of a software interface of a simulation platform for a digital twin modeling mechanism according to a specific embodiment of the present invention;
Fig. 4 is a schematic flowchart of a digital twin modeling mechanism according to a specific embodiment of the present invention.

### Specific Embodiments

Specific embodiments of the present invention will be described below with reference to the drawings.

A digital twin modeling and simulation mechanism provided by the present invention is divided into two parts: modeling and simulation, wherein, in the modeling part, a common manufacturing model ontology is used to describe relationships among all aspects of manufacturing, and field data from the site are integrated to establish a semantic model instance on the basis of the manufacturing model ontology. In the simulation part, a semantic search function is used to extract useful information and results, and transfer the information and results to a production digital twin simulation platform for simulation.

Among them, a semantic model is used to, by using an ontology description language, describe a manufacturing process, which is known as a knowledge graph. A manufacturing model ontology is a predefined standard, for example, the ISA95 standard, which is a unified standard widely used in the field of manufacturing. Specifically, most standards are used to describe models, objects, activities, and integration in manufacturing. Each standard is based on a specific descriptive element.

A digital twin modeling and simulation method provided by the present invention comprises the following steps:
First, step S1 is performed to generate a manufacturing model ontology according to different protocols in the field, acquire site field data, and generate a semantic model template on the basis of the manufacturing model ontology and the field data.

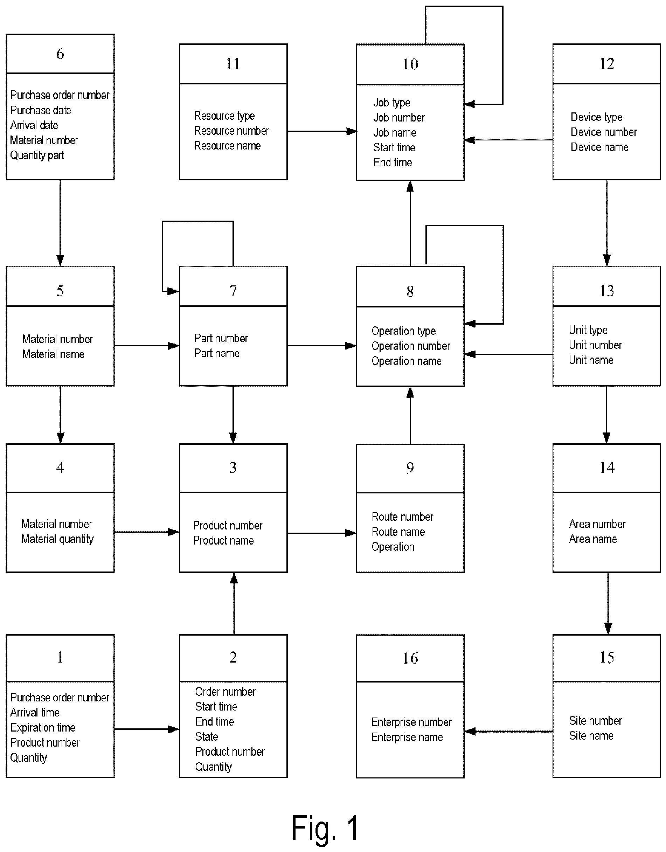

In this embodiment, it is assumed that the manufacturing model ontology is based on the ISA95 standard. On the basis of the ISA95 standard, the manufacturing model ontology is demonstrated by the semantic model shown in Fig. 1. The manufacturing model ontology shown in Fig. 1 has four basic elements: individuals, class, object property, and data property. Among them, class is the core element of the manufacturing model ontology based on the ISA95 standard, and is an abstraction of individuals. Object property is used to describe a relationship between different classes. Data property is used to describe class characteristics. The production, operation, and topology in manufacturing are regulated by an ontology web language and integrated into the common manufacturing model ontology as shown in Fig. 1.

As shown in Fig. 1, the manufacturing model ontology based on the ISA95 standard is divided, according to classification and attributes of site field data, into purchase order, resources, job, equipment, material, part, operation, work unit, raw material, product, routing, area, sales order, order, enterprise, and site.

Specifically, as shown in Fig. 1, the attribute of the sales order 1 comprises a purchase order number, an arrival time, an expiration time, a state, a product number, and a quantity, the attribute of the order 2 comprises an order number, a start time, an end time, a state, a product number, and a quantity, the attribute of the product 3 comprises a product number and a product name, the attribute of the raw material 4 comprises a material number and a material quantity, the attribute of the material 5 comprises a material number and a material name, the attribute of the purchase order 6 comprises a purchase order number, a purchase date, an arrival date, a material number, and a quantity, the attribute of the part 7 comprises a part number and a part name, the attribute of the operation 8 comprises an operation type, an operation number, and an operation name, the attribute of the routing 9 comprises a route number, a route name, and an operation, the attribute of the job 10 comprises a job type, a job number, a job name, a start time, and an end time, the attribute of the resource 11 comprises a resource type, a resource number, and a resource name, the attribute of the device 12 comprises a device type, a device number, and a device name, the attribute of the work unit 13 comprises a unit type, a unit number, and a unit name, the attribute of the area 14 comprises an area number and an area name, and the attribute of the site 15 comprises a site number and a site name. The attribute of the enterprise 16 comprises an enterprise number and an enterprise name.

The above-described classification is made in the entire manufacturing process, wherein, for example, a sales order 1 is received to start the manufacturing, then the sales order 1 is converted into a production order 2, the production order 2 is used to produce a product 3, and the product 3 requires a raw material 4. Among them, according to the different compositions of the product 3, the material 5 describes in detail specific materials required by the different compositions of the entire product. Specific materials are purchased by a purchase order 6. Among them, the part 7 is an intermediate generation part of different compositions of the entire product, which is manufactured by a single production step provided by the operation 8. Further, the operation 8 is divided into a plurality of jobs 10. Among them, the product 3 is manufactured according to the routing 9. Among them, a different device 12 is used for the job 10, the device 12 belongs to a work unit 13, and the work unit 13 is a set of devices with the same functional attribute. In addition, the work unit 13 belongs to a different area 14, the area 14 belongs to a specific site 15, and the site 15 belongs to a different enterprise 16.

On the basis of a common manufacturing model ontology, a piece of specific site data comprises topology data, device data, product and production data, which can generate a site instance. For example, a site has two machines, of which one is used for drilling operation and the other is used for assembling operation. The site is involved in the manufacture of tables and chairs. The routing for a table consists of two steps: first performing a drilling operation and then performing an assembling operation. If the site receives a sales order for 100 tables.

Therefore, a semantic model instance is generated on the basis of the manufacturing model ontology shown in Fig. 1 and the field data of this embodiment, and field data comprise specific sales orders, products, routings, raw materials, materials, operations, devices, and sites, as well as the attributes of the above-described entities.

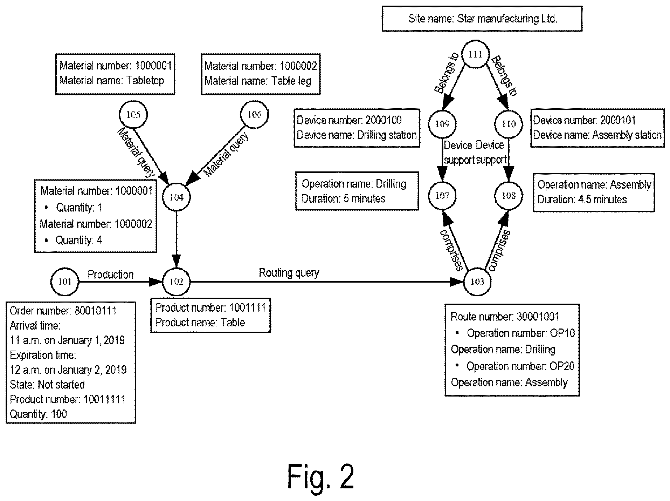

Fig. 2 shows an example of a semantic model according to a specific embodiment of the present invention, and the example of a semantic model in this embodiment comprises a plurality of entities and entity attributes, wherein the entities include: a sales order 101, a product 102, a routing 103, a raw material 104, a material 105, a material 106, an operation 107, an operation 108, a first device 109, a second device 110, and a first site 111. Each of the above entities has one or more entity attributes.

As shown in Fig. 2, the site receives a sales order 101 for 100 tables, and the attribute of the sales order 101 comprises an order number, an arrival time, an expiration time, a product number, and a quantity, wherein the order number is "80010111", the arrival time is "11 a.m. on January 1, 2019", the expiration time is "12 a.m. on January 2, 2019", the state is "Not started", the product number is "10011111", and the quantity is "100". This means that the site has received a sales order for the production of 100 tables, manufacturing has not been started, and the sales order needs to be completed between "11 a.m. on January 1, 2019 and 12 a.m. on January 2, 2019". For the sales order 101, a product 102 is produced, wherein the attribute of the product 102 comprises a product number and a product name, the product number being "1001111", the product name being "table". The attribute of the raw material 104 of the product 102 comprises a material name and a material quantity. The raw material 104 is further divided into a material 105 for a tabletop and a material 106 for a table leg, wherein the attribute of the material 105 for a tabletop comprises a material number and a material name, and the attribute of the material 106 for a table leg comprises a material number and a material name. Further, the material number of the material 105 for a tabletop is "1000001", the name of the material 105 for a tabletop is "tabletop", the material number of the material 106 for a table leg is "1000002", and the material name of the material 106 for a table leg is "table leg".

In addition, the product 102 is manufactured on the basis of the routing 103, and the attribute of the routing 103 comprises a route number, an operation number, and an operation name. Among them, the route number is "30001001", the first operation number is "OP10", the second operation number is "OP20", the operation name of the first operation is "drilling", and the operation name of the second operation is "assembly". The routing 103 comprises a first operation 107 and a second operation 108. Further, the attribute of the first operation 107 comprises an operation name and a duration, wherein the operation name is "drilling" and the duration is "5 minutes". Further, the attribute of the second operation 108 comprises an operation name and a duration, wherein the operation name is "assembly" and the duration is "4.5 minutes". In addition, the first operation 107 is performed in the first device 109, wherein the device number of the first device 109 is "2000100", and the device name of the first device 109 is "drilling station". The second operation 108 is performed in the first device 110, wherein the device number of the second device 110 is "2000101", and the device name of the second device 110 is "assembly station". Both the first device 109 and the second device 110 belong to the first site 111, and the attribute of the first site 111 comprises a site name, wherein the site name is "Star manufacturing Ltd.".

The relationships among a plurality of entities of the above semantic model instance are shown in Fig. 2. Specifically, for the sales order 101, the product 102 is produced, and the routing 103 for producing the product 102 is obtained by performing a routing query. The product 102 has material requirements such as the raw material 104, wherein the raw material 104 learns the material 105 for a tabletop and the material 106 for a table leg after performing a material query. The routing 103 comprises a first operation 107 and a second operation 108. Among them, the first operation 107 is performed by the first device 109 for equipment support, and the second operation 108 is performed by the second device 110 for equipment support. The first device 109 and the second device 110 belong to the first site 111.

Then, step S2 is performed to search for the attribute of the field data according to the type of the field data, extract data from the semantic model instance according to the search result, and simulate the semantic model instance on a simulation platform.

In order to automatically generate a semantic model instance, the present invention needs some key information from the site side. With the present invention, a semantic search needs to be performed to extract this information in a semantic model instance. In order to perform a semantic search, a query function library has been developed in the present invention, and the query function library comprises: a machine search, an order search, a material search, and a routing search. When a semantic search is performed, the query function comprises a plurality of parameters.

First, a search is performed for all the devices in the first site 111 in the semantic model instance shown in Fig. 2, which means searching for and listing all the devices connected to Star manufacturing Ltd. Specifically, the devices connected to Star manufacturing Ltd. include the first device 109 and the second device 110.

Then, in the semantic model instance, a search is performed for sales orders and all their attributes by date, and "January 1" is entered into the semantic model search function, wherein the sales order 101 and its attribute information may be found, including the order number, arrival time, expiration time, product number, and quantity.

Next, in the semantic model instance, a search is performed for raw materials and all their attributes by product, and "table" is entered into the semantic model search function, wherein the raw material 104 of the product 102 may be found, and the attribute of the raw material 104 comprises a material name and a material quantity.

Finally, in the semantic model instance, according to the product search routing, "table" is entered into the semantic model search function, and it may be found that the product 102 is manufactured on the basis of the routing 103, wherein the attribute of the routing 103 comprises a route number, an operation number, and an operation name. Among them, the route number is "30001001", the first operation number is "OP10", the second operation number is "OP20", the operation name of the first operation is "drilling", and the operation name of the second operation is "assembly".

Information acquired by searching a semantic model in the present invention may be used to automatically generate production digital twins. When the production digital twin module receives a model generation request, a semantic search is triggered in the semantic model instance. A search result will be received by some communication methods between the production digital twin model and the knowledge graph module. Once the production digital twin model receives information obtained by searching a semantic model, some functional modules will perform the functions of a normative model.

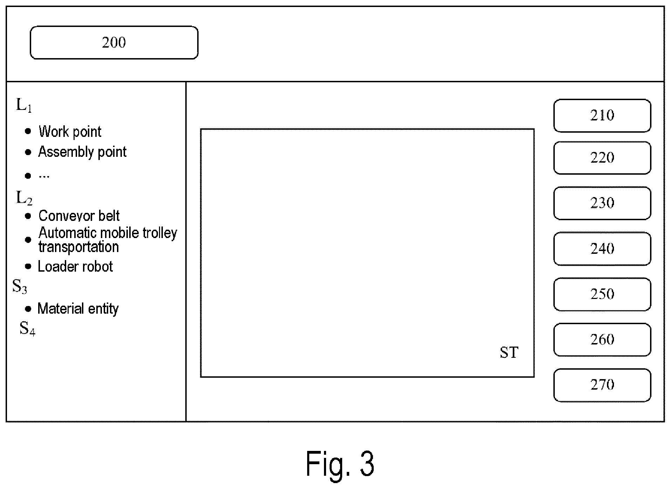

With the present invention, simulation is performed on a semantic model instance on a simulation platform, wherein the simulation platform is optionally commercial event-driven simulation software that has undergone secondary development. Fig. 3 is a schematic diagram of a software interface of a simulation platform for a digital twin modeling mechanism according to a specific embodiment of the present invention. As shown in Fig. 2, the simulation platform 200 comprises a simulation template SF. The left side of the simulation template SF comprises various element resource libraries for simulation: a device library L₁, a transfer library L₂, a material space S₃, and a source space S₄. The right side of the simulation template SF comprises various functional modules that perform simulation functions cooperatively, comprising a semantic search module 210, a device generation module 220, a material preparation module 230, an order management module 240, a process management module 250, a logic management module 260, and a key performance index module 270.

Among them, the simulation template SF is used for the visualization and simulation of production digital twins. The device library L₁ comprises different assembly stations and dismantle stations. All work points are able to download a routing on the basis of an operation definition and a processing part. In the device library L₁, the device element waits for the device to generate a command, and, on receiving a command, the device element will be named and presented in the simulation template SF. The transfer library L₂ comprises all the physical connections between the elements of the work points. The material space S₃ is used to accommodate material elements for production digital twins, which comprises an original material entity in default. In a model, the materials required for a job automatically generated for a specific production are copies of the original material entity in default in the material space. For example, in this embodiment, it comprises a table, a tabletop, and a table leg. Among them, the transfer library L₂ exemplarily comprises a conveyor belt, an automatic mobile trolley transportation and a loader robot.

As shown in Fig. 3, the simulation platform 200 is used to receive a request for automatic generation and simulation of digital twins, and reset the simulation template after the simulation job is completed. Among them, the semantic search module 210 is used to perform a series of query and search operations on a semantic model instance, and a search result is used to automatically generate digital twins. The device generation module 220 is used to generate devices on the simulation template ST on the simulation platform 200 according to device type and location. The order management module 240 is used to download an order and its attribute parameters from a semantic model instance. The material preparation module 230 is configured to set a product, a raw material, and a part in the material space on the simulation template ST by using a copy of the original material entity on the basis of an order. In addition, the material preparation module 230 is further used to download a raw material to the source container in the simulation template ST on the basis of an order sequence predefined by the order management module 240 in a semantic model instance. The process management module 250 detects the parts executed at each work point and sends a command to the work point to establish the execution time, set time, and other process information of the work point before a part reaches the work point. The logic management module 260 is used to define a part flow path from one work point to another work point, which has been defined in the routing. The key performance index module 270 is used to record all the key performance indices in the simulation process. The process management module 250 also specifies the operation duration to the simulation template ST.

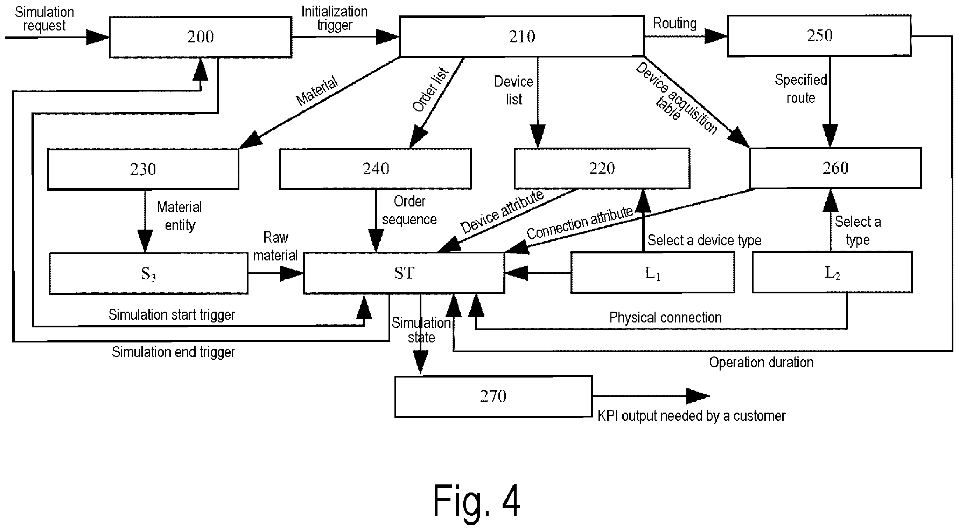

Fig. 4 is a schematic flowchart of a digital twin modeling mechanism according to a specific embodiment of the present invention. After the modeling step S1 and the simulation step S2 provided by the present invention are performed, production digital twins may be automatically generated.

As shown in Fig. 4, after receiving a request for generation and simulation of a production digital twin model, the simulation platform 200 completes the initialization trigger, and specifies the semantic search module 210 to perform a semantic search and acquire a search result. The routing of the semantic search module 210 is acquired from the process management module 250. Then, the device is set from the preset device library L₁ in the simulation template SF, and the material preparation module 230 is instructed to prepare materials with a copy of the original material entity in the material space S₃, and provide raw materials to the simulation template SF. In addition, the order management module 240 downloads an order in a predefined order sequence and provides it to the simulation template SF. Then, on the basis of the order and material information, the raw materials are downloaded to the raw material container in the simulation template SF. The device generation module 220 sends the device attributes to the simulation template SF, and selects the device type from the device library L₁. In addition, the semantic search module 210 acquires materials from the material preparation module 230, the semantic search module 210 acquires an order list from the order management module 240, the semantic search module 210 acquires a device list from the device generation module 220, and the semantic search module 210 acquires a device acquisition table from the logic management module 260.

Then, simulation is triggered, and the process management module 250 specifies a device and automatically selects a process time before placing the product on the device in the simulation. The logic management module 260 detects a manufacturing state in each device, and, when a device has completed an operation on the basis of a part, the logic management module 260 specifies the production part to be transported to the downstream workstation on the basis of the routing of the product. During the execution of the simulation, the key performance index module 270 records key performance indices for products, devices, and lines, including device utilization, line balance rate, productivity, and throughput. The logic management module 260 selects a type of transfer mode from the transfer library L₂, and the transfer library L₂ provides a physical connection between workstations in the simulation template SF. The process management module 250 specifies a route to the logic management module 260, and the logic management module 260 specifies connection attributes to the simulation template SF.

Finally, when simulation is triggered, all the key performance indices are sent back for further analysis, which means that the simulation template SF reports the simulation state to the key performance index module 270 and sends the KPI output needed by a customer.

A second aspect of the present invention provides a digital twin modeling and simulation system, which comprises:
a processor; and a memory coupled to the processor, the memory storing an instruction that, when executed by a processor, causes the electronic device to perform actions, the actions comprising: S1, generating a manufacturing model ontology, acquiring field data, and generating a semantic model instance on the basis of the manufacturing model ontology and the field data; and S2, searching for the attribute of the field data according to the type of the field data, extracting data from the semantic model instance according to the search result, and simulating the semantic model instance on a simulation platform.

Further, the simulation platform comprises: a semantic search module; a device generation module; a material preparation module; an order management module; a process management module; a logic management module; a key performance index module.

Further, a resource library of the simulation platform comprises a device library, a transfer library, and a material space.

Further, the step S2 further comprises the following steps: the simulation platform, after receiving a request for generation and simulation of a production digital twin model, completes the initialization trigger, and specifies the semantic search module to perform a semantic search and obtain a search result; a routing of the semantic search module is acquired from the process management module, the device is set from a preset device library in a simulation template, the material preparation module is instructed to prepare the material with a copy of the original material entity in the material space and provide the raw material to the simulation template, and the order management module downloads orders in a predefined order sequence and provides them to the simulation template; simulation is triggered, and the process management module specifies a device and automatically selects process time before placing the product on the device in the simulation. The logic management module detects a manufacturing state in each device and, when a device has completed an operation on the basis of a part, the logic management module specifies the production part to be transported to the downstream workstation on the basis of the routing of the product; when the simulation trigger is completed, the simulation template reports the simulation state to the key performance index module and sends the key performance output needed by a customer.

Further, the manufacturing model ontology comprises individuals, class, object property, and data property. Further, the manufacturing model ontology is divided, according to classification and attributes of site field data, into purchase order, resources, job, equipment, material, part, operation, work unit, raw material, product, routing, area, sales order, order, enterprise, and site.

A third aspect of the present invention provides a digital twin modeling and simulation device, which comprises:
a modeling device for generating a manufacturing model ontology, acquiring field data, and generating a semantic model instance on the basis of the manufacturing model ontology and
the field data; a simulation device for searching for the attribute of the field data according to the type of the field data, extracting data from the semantic model instance according to the search result, and simulating the semantic model instance on a simulation platform.

A fourth aspect of the present invention provides a computer program product that is tangibly stored on a computer-readable medium and comprises a computer-executable instruction, and the computer-executable instruction, when executed, causes at least one processor to perform the method according to the first aspect of the present invention.

A fifth aspect of the present invention provides a computer-readable medium storing a computer-executable instruction, and when executed, the computer-executable instruction causes at least one processor to perform the method according to the first aspect of the present invention.

A digital twin modeling and simulation mechanism provided by the present invention is capable of being applied to all types of manufacturing, and it is a manufacturing ontology based on a unified standard, which fully demonstrates the flexibility of the present invention. The present invention allows a reduction of the dependence on experts in this field for production modeling work, and a decrease in the manpower input in complex production digital twins.

While the present invention has been described in detail with the above-mentioned preferred embodiments, it should be understood that the above description should not be deemed to limit the present invention. Various modifications and substitutions of the present invention will be readily apparent to those of ordinary skill in the art after they read the above description. Therefore, the scope of protection of the present invention should be defined by the appended claims. In addition, no reference numerals specified in a claim should be construed as limiting an involved claim. The term "comprising" does not exclude any devices or steps that are not listed in other claims or the description; terms such as "first" and "second" are used to indicate designations, and do not indicate any specific order.

## Claims

1. A digital twin modeling and simulation method, which comprises the following steps:
S1, generating a manufacturing model ontology, acquiring field data, and generating a semantic model instance on the basis of the manufacturing model ontology and the field data; and
S2, searching for the attribute of the field data according to the type of the field data, extracting data from the semantic model instance according to the search result, and simulating the semantic model instance on a simulation platform.

2. The digital twin modeling and simulation method as claimed in claim 1, **characterized in that** the simulation platform comprises:
- a semantic search module;
- a device generation module;
- a material preparation module;
- an order management module;
- a process management module;
- a logic management module;
- a key performance index module.

3. The digital twin modeling and simulation method as claimed in claim 2, **characterized in that** a resource library of the simulation platform comprises a device library, a transfer library, and a material space.

4. The digital twin modeling and simulation method as claimed in claim 1, **characterized in that** the step S2 further comprises the following steps:
the simulation platform, after receiving a request for generation and simulation of a production digital twin model, completes the initialization trigger, and specifies the semantic search module to perform a semantic search and obtain a search result;
a routing of the semantic search module is acquired from the process management module, the device is set from a preset device library in a simulation template, the material preparation module is instructed to prepare the material with a copy of the original material entity in the material space and provide the raw material to the simulation template, and the order management module downloads orders in a predefined order sequence and provides them to the simulation template;
simulation is triggered, and the process management module specifies a device and automatically selects process time before placing the product on the device in the simulation. The logic management module detects a manufacturing state in each device and, when a device has completed an operation on the basis of a part, the logic management module specifies the production part to be transported to the downstream workstation on the basis of the routing of the product;
when the simulation trigger is completed, the simulation template reports the simulation state to the key performance index module and sends the key performance output needed by a customer.

5. The digital twin modeling and simulation method as claimed in claim 1, **characterized in that** the manufacturing model ontology comprises individuals, class, object property, and data property.

6. The digital twin modeling and simulation method as claimed in claim 5, **characterized in that** the manufacturing model ontology is divided, according to classification and attributes of site field data, into purchase order, resources, job, equipment, material, part, operation, work unit, raw material, product, routing, area, sales order, order, enterprise, and site.

7. A digital twin modeling and simulation system, which comprises:
a processor; and
a memory coupled to the processor, the memory storing an instruction that, when executed by a processor, causes the electronic device to perform actions, the actions comprising:
S1, generating a manufacturing model ontology, acquiring field data, and generating a semantic model instance on the basis of the manufacturing model ontology and the field data; and
S2, searching for the attribute of the field data according to the type of the field data, extracting data from the semantic model instance according to the search result, and simulating the semantic model instance on a simulation platform.

8. The digital twin modeling simulation system as claimed in claim 7, **characterized in that** the simulation platform comprises:
- a semantic search module;
- a device generation module;
- a material preparation module;
- an order management module;
- a process management module;
- a logic management module;
- a key performance index module.

9. The digital twin modeling simulation system as claimed in claim 8, **characterized in that** a resource library of the simulation platform comprises a device library, a transfer library, and a material space.

10. The digital twin modeling simulation system as claimed in claim 7, **characterized in that** the action S2 also comprises the following steps:
the simulation platform, after receiving a request for generation and simulation of a production digital twin model, completes the initialization trigger, and specifies the semantic search module to perform a semantic search and obtain a search result;
a routing of the semantic search module is acquired from the process management module, the device is set from a preset device library in a simulation template, the material preparation module is instructed to prepare the material with a copy of the original material entity in the material space and provide the raw material to the simulation template, and the order management module downloads orders in a predefined order sequence and provides them to the simulation template;
simulation is triggered, and the process management module specifies a device and automatically selects process time before placing the product on the device in the simulation. The logic management module detects a manufacturing state in each device and, when a device has completed an operation on the basis of a part, the logic management module specifies the production part to be transported to the downstream workstation on the basis of the routing of the product;
when the simulation trigger is completed, the simulation template reports the simulation state to the key performance index module and sends the key performance output needed by a customer.

11. The digital twin modeling simulation system as claimed in claim 7, **characterized in that** the manufacturing model ontology comprises individuals, class, object property, and data property.

12. The digital twin modeling simulation system as claimed in claim 11, **characterized in that** the manufacturing model ontology is divided, according to classification and attributes of site field data, into purchase order, resources, job, equipment, material, part, operation, work unit, raw material, product, routing, area, sales order, order, enterprise, and site.

13. A digital twin modeling and simulation device, comprising:
a modeling device for generating a manufacturing model ontology, acquiring field data, and generating a semantic model instance on the basis of the manufacturing model ontology and
the field data;
a simulation device for searching for the attribute of the field data according to the type of the field data, extracting data from the semantic model instance according to the search result, and simulating the semantic model instance on a simulation platform.

14. A computer program product that is tangibly stored on a computer-readable medium and comprises a computer-executable instruction, wherein the computer-executable instruction, when executed, causes at least one processor to execute the method as claimed in any of claims 1 to 6.

15. A computer-readable medium storing a computer-executable instruction that, when executed, causes at least one processor to execute the method as claimed in any one of claims 1 to 6.
